(19) **Europäisches Patentamt European Patent Office Office européen des brevets**

(11) **EP 1 494 079 B1**

(12) **EUROPEAN PATENT SPECIFICATION**

(45) Date of publication and mention
of the grant of the patent:
**02.01.2008 Bulletin 2008/01**

(51) Int Cl.:
***G03F 7/20*** (2006.01)

(21) Application number: **04253817.3**

(22) Date of filing: **25.06.2004**

(54) **Lithographic Apparatus**

Lithographischer Apparat

Appareil lithographique

(84) Designated Contracting States:
**DE FR GB IT NL**

(30) Priority: **27.06.2003 EP 03254078**

(43) Date of publication of application:
**05.01.2005 Bulletin 2005/01**

(73) Proprietor: **ASML Netherlands B.V.**
**5504 DR Veldhoven (NL)**

(72) Inventors:
- **Cox, Henrikus Herman Marie**
**5646 JH Eindhoven (NL)**
- **Donders, Sjoerd Nicolaas Lambertus**
**5211 HN s-Hertogenbosch (NL)**
- **Hoogendam, Christiaan Alexander**
**5509 NC Veldhoven (NL)**
- **Kolesnychenko, Aleksey Yurievich**
**5701 EE Helmond (NL)**

- **Loopstra, Erik Roelof**
**5591 BA Heeze (NL)**
- **Van Santen, Helmar**
**1018 BB Amsterdam (NL)**

(74) Representative: **Leeming, John Gerard**
**J.A. Kemp & Co.**
**14 South Square**
**Gray's Inn**
**London WC1R 5JJ (GB)**

(56) References cited:
**EP-A- 1 598 855       WO-A-01/84241**
**WO-A-99/49504       US-A- 5 610 683**

- **PATENT ABSTRACTS OF JAPAN vol. 1999, no. 03, 31 March 1999 (1999-03-31) -& JP 10 340846 A (NIKON CORP), 22 December 1998 (1998-12-22)**

## Description

The present invention relates to a lithographic apparatus and a device manufacturing method.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

It has been proposed to immerse the substrate in the lithographic projection apparatus in a liquid having a relatively high refractive index, e.g. water, so as to fill a space between the final element of the projection system and the substrate. The point of this is to enable imaging of smaller features since the exposure radiation will have a shorter wavelength in the liquid. (The effect of the liquid may also be regarded as increasing the effective NA of the system and also increasing the depth of focus.) Other immersion liquids have been proposed, including water with solid particles (e.g. quartz) suspended therein.

However, submersing the substrate or substrate and substrate table in a bath of liquid (see for example US 4,509,852) means that there is a large body of liquid that must be accelerated during a scanning exposure. This requires additional or more powerful motors and turbulence in the liquid may lead to undesirable and unpredictable effects.

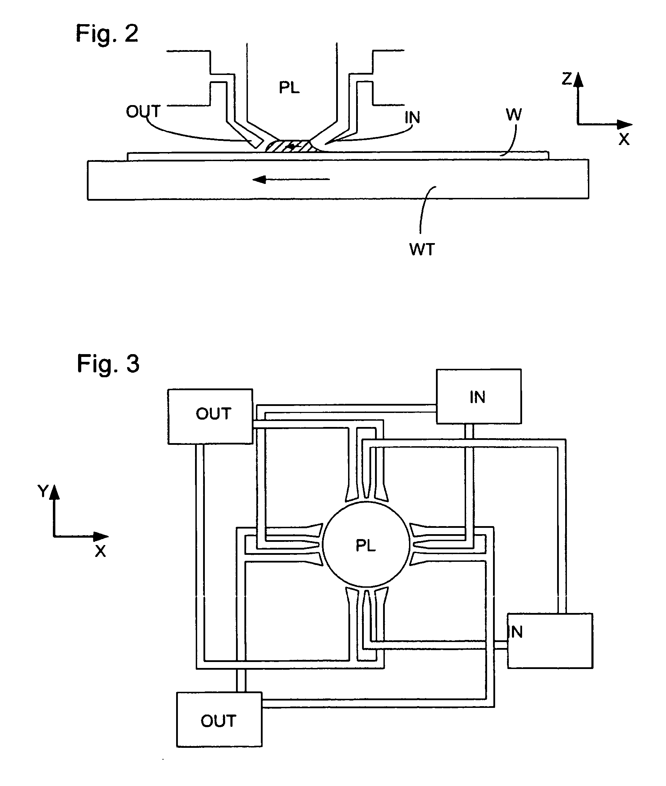

One of the solutions proposed is for a liquid supply system to provide liquid on only a localized area of the substrate and in between the final element of the projection system and the substrate using a liquid confinement system (the substrate generally has a larger surface area than the final element of the projection system). One way which has been proposed to arrange for this is disclosed in WO 99/49504. As illustrated in Figures 2 and 3, liquid is supplied by at least one inlet IN onto the substrate, preferably along the direction of movement of the substrate relative to the final element, and is removed by at least one outlet OUT after having passed under the projection system. That is, as the substrate is scanned beneath the element in a X direction, liquid is supplied at the +X side of the element and taken up at the -X side. Figure 2 shows the arrangement schematically in which liquid is supplied via inlet IN and is taken up on the other side of the element by outlet OUT which is connected to a low pressure source. In the illustration of Figure 2 the liquid is supplied along the direction of movement of the substrate relative to the final element, though this does not need to be the case. Various orientations and numbers of in- and out-lets positioned around the final element are possible, one example is illustrated in Figure 3 in which four sets of an inlet with an outlet on either side are provided in a regular pattern around the final element.

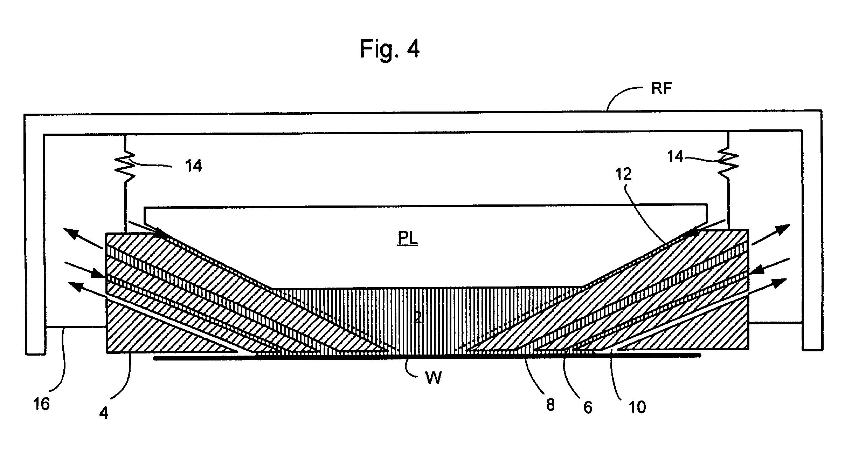

Another solution which has been proposed is to provide the liquid supply system with a seal member which extends along at least a part of a boundary of the space between the final element of the projection system and the substrate table. Such a solution is illustrated in Figure 4. The seal member is substantially stationary relative to the projection system in the XY plane though there may be some relative movement in the Z direction (in the direction of the optical axis). A seal is formed between the seal member and the surface of the substrate. Preferably the seal is a contactless seal such as a gas seal. Such as system with a gas seal is disclosed in European Patent Application No. 03252955.4

In European Patent Application No. 03257072.3 and in the corresponding published European Patent Application EP 1,420,300 A considered as forming part of the prior art according to Article 54(3) EPC the idea of a twin or dual stage immersion lithography apparatus is disclosed. Such an apparatus is provided with two stages for supporting the substrate. Leveling measurements are carried out with a stage at a first position, without immersion liquid, and exposure is carried out with a stage at a second position, where immersion liquid is present. Alternatively, the apparatus has only one stage.

However, while a gas seal seals the liquid effectively it can present further problems. A relatively high gas pressure is required (with overpressure or gauge pressure relative to the environment of 100-10000 Pa) and this combined with the relatively low damping of a gas seal means that vibrations can be transmitted through the gas seal causing an adverse effect on the performance of the imaging system. The vibrations due to pressure disturbances can cause servo errors of between 1 to 20 nm in the vertical direction and 1-50 nm horizontally.

It is an object of the present invention to provide an effective seal to contain the liquid in a space between the final element of the projection system and the surface of a substrate being imaged.

This and other objects are achieved according to the invention in a lithographic projection apparatus comprising:

- a radiation system for providing a projection beam (PB) of radiation;

- a support structure (MT) for supporting patterning means (MA), the patterning means serving to pattern the projection beam according to a desired pattern;
- a substrate table (WT) for holding a substrate (W);
- a projection system (PL) for projecting the patterned beam onto a target portion of the substrate; and
- a liquid supply system for providing a space between a final element of said projection system and said substrate with a liquid; characterized in that said liquid supply system comprises:

  - a seal member arranged between the final element of the projection system (PL) and the surface of the substrate (W) and extending along at least part of the boundary of said space between the final element of said projection system and said substrate; and

  - a liquid seal means for forming a seal between said seal member and the surface of the substrate, by a flow of liquid.

This construction has the advantage that no gas supply is required. Therefore, no bubbles can form in the liquid because of the gas supply. The liquid seal is operative to retain the liquid in the space and also to prevent the inclusion of gas from the environment of the apparatus which surrounds the substrate table. The liquid also has good damping characteristics, which reduces the transmission of disturbances (e.g. from the supply and removal of liquid) through the seal. Additionally, the construction of the seal is simplified because there is no need to provide a gas inlet to the seal as there is with a gas seal. Furthermore, a liquid seal can be effective with a smaller volume and/or a greater gap height than a corresponding gas seal. A greater gap height imposes less strict mechanical specifications on the substrate, substrate table and seal member.

Optionally, said liquid seal means is either a hydrostatic or hydrodynamic bearing for supporting said seal member above the surface of said substrate. The provision of a hydrostatic or hydrodynamic bearing for both support and sealing allows the seal to function over a larger gap range, for example up to 1mm, preferably in the range 10 to 300 $\mu$m. The bearing has stiffness and damping in 3 degrees of freedom: in the vertical (z) direction, and rotation about axes perpendicular to the z direction. It will therefore also function as suspension for the seal member.

Optionally, the pressure of the liquid in said hydrostatic bearing is in the range of 100 Pa to 100 kPa relative to the ambient pressure. Ambient pressure refers to pressure in the apparatus surrounding the liquid filled space. If the bearing pressure is in this range, the bearing will function as suspension for the seal member and transmit fewer vibrations than a comparable gas seal.

Optionally, said seal member further comprises a shared liquid outlet for removing liquid from said space and from said liquid seal means. By providing a shared liquid outlet for both the liquid seal means and the liquid filled space, the construction is further simplified.

Optionally, said shared outlet is located on a surface of said seal member which faces said substrate and is positioned between said space and said liquid seal means. The liquid in the seal will generally be at a higher pressure than the liquid in the space and therefore this pressure gradient will ensure that liquid supplied to the seal moves radially inwards towards the optical axis, improving the effectiveness of the seal.

Optionally, said shared liquid outlet has a cross sectional area in a plane substantially parallel to said substrate which is greater than the cross sectional area of a liquid inlet. The greater cross-sectional area allows the flow in the outlet to be laminar. This reduces turbulence in the liquid filling the space which can have an adverse and chaotic effect on accuracy.

Positioning of a liquid inlet on a surface of said seal member which faces said substrate allows liquid to flow in an inward radial direction towards the liquid filled space. This reduces the flow of liquid in an outward radial direction and provides a more effective seal.

Optionally, the height of said seal member above the surface of said substrate is greater in the region between said space and said liquid inlet than elsewhere. By varying the height in this way the pressure of liquid supplied is reduced for the same rate of refreshment of liquid in the space. This reduces the transmission of unwanted vibrations. It also reduces the flow of liquid in an outward radial direction. This is beneficial because liquid flowing in this direction must be removed and removing a large amount, e.g. by vacuum suction, can induce unwanted vibrations in the apparatus.

Optionally, said liquid supply system further comprises a gas seal means positioned outwards in a radial direction from said liquid inlet, for forming a gas seal between said seal member and the surface of said substrate.

Optionally, said seal member further comprises an intermediate gas inlet and a liquid outlet respectively positioned outwards in a radial direction from said liquid inlet and both located on said surface of said seal member which faces said substrate. The liquid outlet removes liquid which might otherwise leak in an outward radial direction. The intermediate gas inlet enhances the removal of the liquid at the liquid outlet.

Optionally, the height of said seal member above the surface of said substrate is greater between said intermediate gas inlet and said liquid outlet than between said liquid inlet and said intermediate gas inlet. This further improves the removal of liquid at the liquid outlet.

Optionally, said liquid supply system further comprises a low pressure source for preventing leakage of liquid in an outward radial direction, said low pressure source located on a surface of said seal member which faces said substrate. A low pressure source removes any liquid which leaks from the seal and stops it encroaching into the rest of the apparatus.

Optionally, the apparatus further comprises means for applying a biasing force directed towards the surface of said substrate to said seal member. By applying a bias force on the seal member towards the substrate the force required to support the seal member can be adjusted as desired. If the liquid seal is a hydrostatic bearing, this allows the steady state operating pressure of the bearing to be adjusted without adjusting the dimensions of the bearing.

Optionally, the apparatus further comprises a member connected between said seal member and a machine frame for supporting said seal member. This allows the position of the sealing member to be maintained in the correct position relative to the lens and can also provide support and suspension for the sealing member.

Optionally, in the apparatus of the above first or said seal member comprises at least one liquid inlet, at least one liquid outlet and at least one combined outlet for both liquid and gas.

Optionally, in the apparatus of the above first or second aspects, said liquid supply system supplies liquid to said space at a rate of 0.1 to 10 liters per minute.

Optionally, said liquid supply system supplies liquid to said space at a pressure which compensates for liquid transported away from said space by relative movement between said substrate and said seal member. This allows the inclusion of gas into the liquid because of relative movement between the substrate and the seal member to be avoided.

Optionally, the apparatus further comprises at least one chamber formed upstream of an inlet and/or downstream of an outlet of said seal member. This allows an even, homogenous flow of liquid and/or gas to be achieved.

Optionally, the apparatus further comprises:

- at least one sensor to establish a distance between the surface of said substrate and said seal member; and
- a control system to control at least one actuator to maintain a desired distance between the surface of said substrate and said seal member based on the distance established by said sensor.

This allows the height of the seal member above the surface of the substrate to be controlled preferably with 3 degrees of freedom, and most preferably with 6 degrees of freedom. The control system preferably also generates a large electronic damping of the seal member resulting in a design that is less sensitive to vibrations from the liquid supply and removal system. The control loop can also be used to effect a real-time mounting of the quality of the seal, allowing rapid action (e.g. retraction of the seal member) in the case of a failure. The apparatus may further comprise a second control system that controls the actuator to compensate for any static force on the seal member. Such static forces may originate from gravity, liquid transport tubing, or from a guidance system for the seal member.

Optionally, in the apparatus of the above first or second aspects, at least one inlet and/or outlet in said member has rounded edges. By rounded it is meant that the edge is not square, rounded accordingly includes arcuate and curved profiles. The degree of curvature depends on the dimensions of the inlet/outlet. The radius of curvature is preferably in the range 0.1 mm to 5 mm. This improves the flow around the edge and reduces turbulence.

Optionally, in the apparatus of the above first or second aspects, at least one edge of said seal member adjacent to the surface of said substrate is rounded. By rounded it is meant that the edge is not square, rounded accordingly includes arcuate and curved profiles. The radius of curvature is preferably in the range 0.1 mm to 15 mm.

The European Patent Application EP 1 598 855 A which is considered as comprised in the prior art according to Article 54(3) EPC discloses (Figure 1) a lithographic projection apparats (EX) comprising a liquid supply system (11,12) for providing a space between a final element (2) of the projection system (PL) and a substrate (P) with a liquid (1). The liquid supply system, comprises a seal member (30) extending along the boundary of the space (see Figures 3 and 4). The liquid supply system further comprises a liquid seal means forming a seal between the seal member and the surface of the substrate by a flow of liquid (see column 19, lines 34-40).

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm).

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

Embodiments of the invention will now be described, by way of example only, with reference to the accompanying schematic drawings in which corresponding reference symbols indicate corresponding parts, and in which:

Embodiments of the invention will now be described, by way of example only, with reference to the accompanying schematic drawings in which:

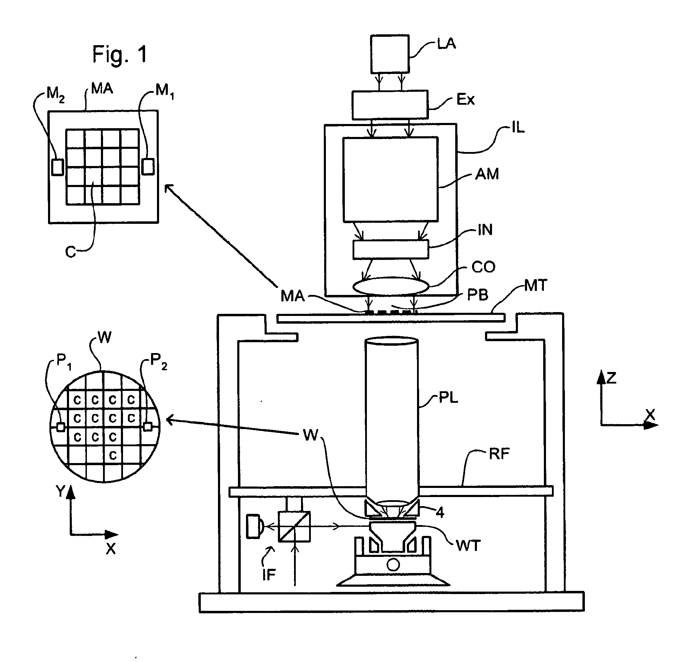

> Figure 1 depicts a lithographic projection apparatus according to an embodiment of the invention;
> Figure 2 depicts a cross section of a liquid supply system which provides liquid in a localized area;
> Figure 3 is a plan view of the liquid supply system of Figure 2;
> Figure 4 depicts a cross section of a liquid supply system according to a first embodiment of the invention;

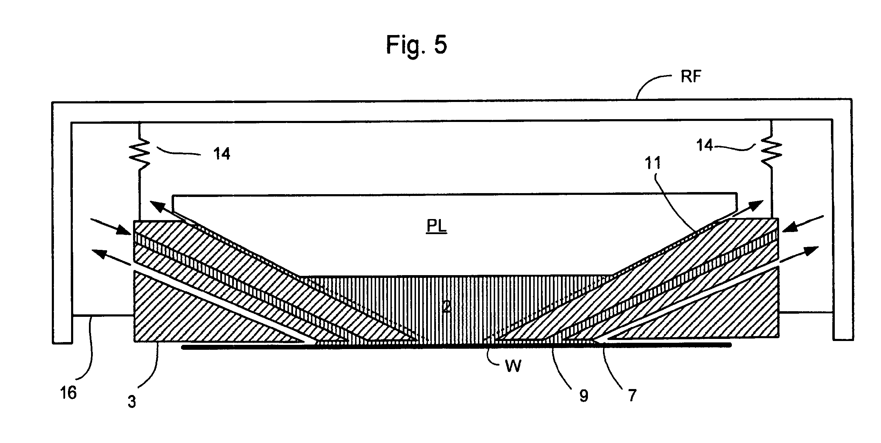

> Figure 5 depicts a cross section of a liquid supply system according to a second embodiment of the invention;

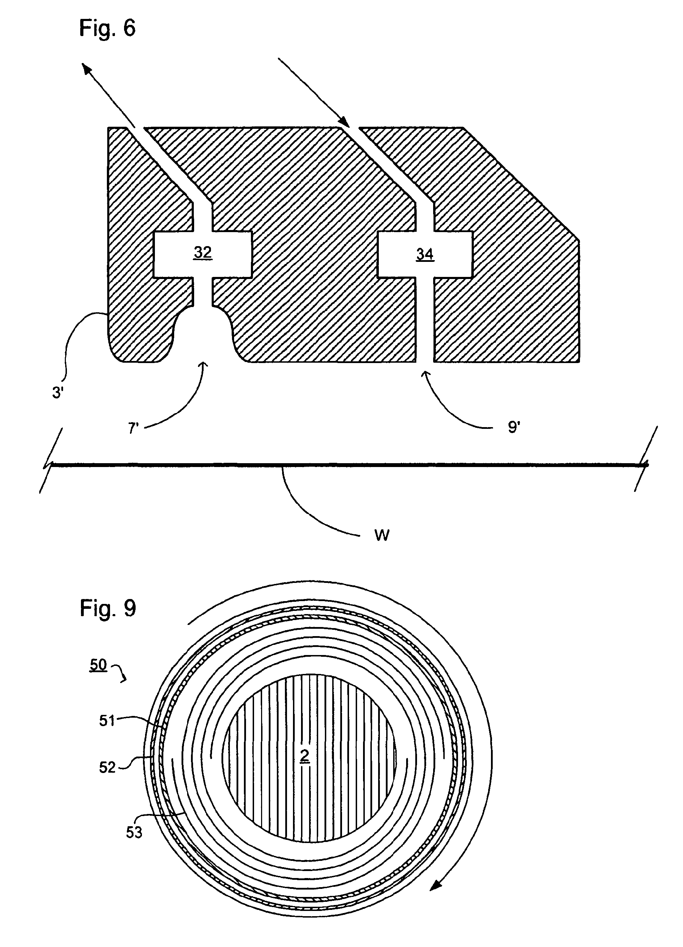

> Figure 6 depicts a cross section of a seal member according to a third embodiment of the present invention;

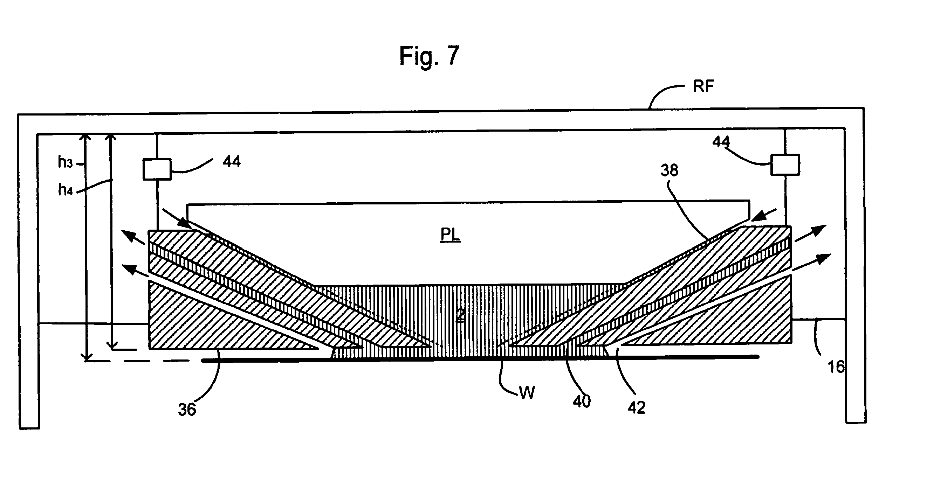

> Figure 7 depicts a cross section of a liquid supply system according to a fourth embodiment of the present invention;

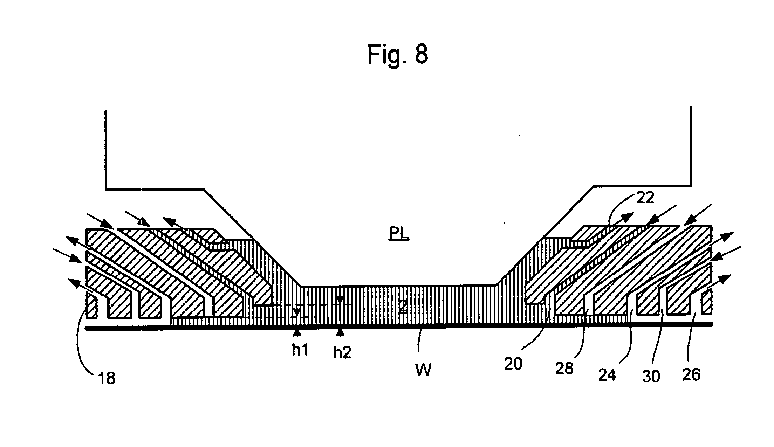

> Figure 8 depicts a cross section of a liquid supply system according to a fifth embodiment of the present invention; and
> Figure 9 depicts a seal member according to a sixth embodiment of the invention.

In the Figures, corresponding reference symbols indicate corresponding parts.

<u>Embodiment 1</u>

Figure 1 schematically depicts a lithographic apparatus according to a particular embodiment of the invention. The apparatus comprises:

- an illumination system (illuminator) IL for providing a projection beam PB of radiation (e.g. UV radiation radiation).
- a first support structure (e.g. a mask table) MT for supporting a patterning device (e.g. a mask) MA and connected to a first positioning device PM for accurately positioning the patterning device with respect to item PL;
- a substrate table (e.g. a wafer table) WT for holding a substrate (e.g. a resist-coated wafer) W and connected to a second positioning device PW for accurately positioning the substrate with respect to item PL; and
- a projection system (e.g. a refractive projection lens) PL for imaging a pattern imparted to the projection beam PB by patterning device MA onto a target portion C (e.g. comprising one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise an adjusting device AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The projection beam PB is incident on the mask MA, which is held on the mask table MT. Having traversed the mask MA, the projection beam PB passes through the lens PL, which focuses the beam onto a target portion C of the substrate W. With the aid of the second positioning device PW and position sensor IF (e.g. an interferometric device), the substrate table WT can be moved accurately, e.g. so as to position different target portions C in the path of the beam PB. Similarly, the first positioning device PM and another position sensor (which is not explicitly depicted in Figure 1) can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:

1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-) magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.

3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

Figure 4 illustrates a liquid supply system according to the first embodiment of the present invention. A liquid fills a space 2 between a final element of the projection system PL and the substrate W. A seal member 4 is arranged between the final clement of the projection system PL and the surface of the substrate W to define the space 2. A liquid seal is formed between the seal member 4 and the surface of the substrate W to prevent leakage of liquid from the space 2.

The seal member 4 has a liquid inlet 6 and a liquid outlet 8 in its surface which faces the substrate (hereinafter referred to as the primary surface). The outlet 8 is located radially inward of the inlet 6 with respect to the optical axis of the projection system. A liquid seal is formed by the flow of liquid from the inlet 6 to an outlet 8. Preferably the liquid seal is formed by a hydrostatic bearing defined by the flow of liquid from the inlet 6 to the outlet 8. This hydrostatic bearing can then support the seal member 4 as well as providing a liquid seal to prevent leakage of the liquid from the space 2.

A vacuum outlet 10 is also formed in the primary surface of the seal member 4, outwards in a radial direction from the inlet 6 with respect to the optical axis, for extracting any liquid which may escape from the seal into the area of the substrate W not immersed in liquid.

An additional liquid inlet 12 is formed in the gap between the final element of the projection system PL and the upper surface of the seal member 4. This additional inlet 12 is used to supply liquid into the space 2. In this embodiment the liquid is primarily distilled water, although other liquids can also be used.

Figure 4 depicts the seal member in cross section. It will be appreciated that the inlets 6 and 12 and the outlets 8 and 10 can extend continually around the liquid filled space 2, forming a groove when viewed from the surface of the substrate. This groove can be annular, rectangular or polygonal. Alternatively the inlets and outlets can be provided at discrete locations in a continuous groove and not extend continuously around the length of the groove.

An additional horizontal member 16 connects the seal member 4 to the sides of a reference frame RF. This member provides support for the seal member in addition to the bearing and also ensures that the correct horizontal position is maintained. It keeps the seal member 4 substantially stationary with respect to the projection system PL in the horizontal, XY plane, but allows relative movement in the vertical, Z, direction and tolts in the vertical plane.

In use the outlet 8 is maintained at a lower pressure than the bearing liquid inlet 6 and therefore liquid will flow from the inlet 6 to the outlet 8. This creates a liquid seal to contain the liquid in the space 2. An additional benefit is that this flow of liquid radially inwards forms a hydrostatic bearing which can support the sealing member 4. A further benefit is that in an emergency the liquid 2 can be rapidly removed via outlet 8 to prevent damage to the apparatus.

However, some liquid may "leak" radially outwards from the hydrostatic bearing into the rest of the apparatus. The vacuum system 10 removes this leaking water and also help to remove any liquid left adhering to the substrate W when the substrate W moves relative to the sealing member 4.

The flow of water into the space 2 via the inlet 12 is advantageously a very laminar flow (i.e. with a Reynolds number of much less than 2300). Likewise the flow of water through the outlet 8 is also preferably a laminar flow. This ensures that there is no turbulence in the liquid filling the space 2 and that there are no disturbances to the optical path through the liquid. The outlet 8 is responsible for removing the liquid from both the inlet 12 for the space and the inlet 6 for the bearing. Therefore, the cross-sectional area of the outlet 8 is larger than that of the inlet 12 to ensure that flow is laminar.

Adjustable passive springs 14 apply a biasing force to the seal member 4 in the direction of the substrate W. This biasing force allows the operating pressure of the hydrostatic bearing to be altered without needing to alter the dimensions of the bearing. The force exerted by the hydrostatic bearing must match the force exerted downwards due to gravity on the bearing and is equal to the pressure multiplied by the effective surface area over which the bearing acts. Therefore if a different operating pressure is desired either the effective area of the bearing must be changed or the force that the bearing supports must be changed. Although in this embodiment a spring 14 has been used to provide the biasing force, other means may also be appropriate, for example an electromagnetic force.

The height of the seal member 4 above the substrate W is adjustable between 10 and 500 μm according to the surface variations of the substrate W (and therefore the liquid flow) which must be accommodated. In this embodiment the gap is increased or decreased by altering the pressure of the hydrostatic bearing such that the seal member 4 moves relative to the substrate W. The pressure of the hydrostatic bearing is then returned to the equilibrium pressure when the correct position has been reached. An alternative method of varying the gap distance could make use of the springs 14. As the distance between the seal member 4 and the reference frame RF is varied the force exerted by the springs 14 will also vary. This means that the height of the seal member 4 above the substrate W can be adjusted by simply adjusting the operating pressure of the bearing.

A typical operating pressure of the hydrostatic bearing is between 100 Pa and 100 kPa overpressure relative to the environment. A preferable operating pressure is 3 kPa. Operation at this pressure allows the bearing to support the seal member 4 effectively and also provide some suspension. The bearing will have stiffness in the vertical direction and also for rotations about axes perpendicular to the vertical direction. In this embodiment the same liquid is supplied to both the inlet 12 for the space and the inlet 6 for the bearing. This allows a common outlet 8 to be used without needing to consider the effects of mixing of two liquids, and possible diffusion from the liquid in the hydrostatic bearing into the liquid filled space 2. However, it need not be the same liquid and a different liquid can be supplied to the inlet 12 for the space and the inlet 6 for the bearing.

Although this embodiment has described providing the inlets and outlets on a surface of the seal member which faces the substrate, this does not have to be the case and other arrangements are possible.

While the use of a hydrostatic bearing has been described, a hydrodynamic bearing could also be used.

Embodiment 2

A cross section of a liquid supply system usable in a lithographic apparatus of the invention is shown in Figure 5. The construction of this embodiment is as for the first embodiment save as described below.

In this embodiment a seal member 3 has a single liquid inlet 9. The inlet 9 is located outwards in a radial direction with respect to the optical axis from a liquid filled space 2 between the final element of the projection system PL and the surface of the substrate W. Liquid supplied by the inlet 9 flows both inwards, into the space 2, and outwards towards an outlet 7. The outlet 7 is connected to a low pressure source. This causes the liquid to be sucked into the outlet 7 and prevented from entering the rest of the apparatus. A further outlet I 1 is provided between the seal member 3 and the projection system PL to remove liquid from the space 2.

Preferably, the flow of liquid in the inlet 9 and outlet 1 is a laminar flow to reduce turbulence. Turbulence in the liquid can have an adverse effect on the imaging process.

The construction of this embodiment is simplified over the above described first embodiment because the liquid supply system only requires a single liquid inlet.

Embodiment 3

A cross section of a seal member usable in a lithographic apparatus of the present invention is shown in Figure 6. The construction of this embodiment is as for the second embodiment, save as described below.

A seal member 3' has a liquid inlet 9' and an outlet 7' which is connected to a low pressure source. The edges of the outlet 7' which face the surface of the substrate W are rounded, as is the edge of the seal member 3' adjacent to the outlet 7'. The rounded edges can have the form of an arc or an arbitrary curved profile. The degree of curvature depends on the dimensions of the inlet/outlet. In this embodiment the radius of curvature is preferably in the range 0.1 mm to 5 mm. This improves the flow around the edge and reduces turbulence. By replacing the square edges with rounded edges in this manner, the flow of gas and/or liquid through the outlet 7' is improved.

To further improve the flow through the outlet 7', a duct or chamber 32 is provided within the seal member in the outlet 7'. This chamber 32 ensures that a homogenous low pressure source is provided.

A chamber 34 is also provided in the liquid inlet 9'. This ensures that an even, homogenous supply of liquid is achieved.

Figure 6 depicts the seal member 3' in cross section. It will be appreciated that the chambers 32 and 34 can extend continuously throughout the seal member or be located at discrete radial locations.

Although this embodiment has described both rounding the edges of the outlet 7' and providing chambers 32 and 34, either of these features could be provided independently of each other if desired. Likewise, the rounding and ducts of this embodiment may be applied to the seal member of the first embodiment described above, and to seal members having different configurations of inlets and outlets.

Embodiment 4

A cross section of a liquid supply system usable in a lithographic apparatus of the present invention is depicted in Figure 7. The construction of this embodiment is as for the first embodiment save as described below.

A seal member 36 delimits a space 2 between the projection system PL and the surface of the substrate W. Liquid is supplied to fill the space 2 formed between the final element of the projection system PL and the seal member 36 via an inlet 38. A liquid outlet 40 is formed in the surface of the seal member 36 which faces the substrate W (hereinafter referred to as the primary surface) and is located outwards in a radial direction from the optical axis of the projection system PL. This outlet 40 removes liquid from the space 2. Preferably, the flow of liquid in the inlet 38 and outlet 40 is a laminar flow. This avoids turbulence in the liquid filling the space 2 which can have an adverse effect on the imaging quality.

A further outlet 42 is formed in the primary surface of the seal member 36 outwards in a radial direction from the liquid outlet 40 and is connected to a low pressure source. This ensures that any liquid which is not removed by the liquid outlet 40 cannot "leak" into the remainder of the apparatus.

The seal member 36 is connected to a reference frame RF by a plurality of Lorentz actuators 44 preferably three of which (only two are shown in Figure 7). These actuators 44 are controlled by a controller to set the vertical position of the seal member 36 above the substrate W.

The controller takes an input of the distance $h_3$ between the surface of the substrate W and the reference frame RF and the distance, $h_4$, between the primary surface of the seal member 36 and the reference frame RF. These distances are measured by sensors (not shown). The controller can therefore calculate the height of the seal member 36 above the surface of the substrate W by subtracting $h_4$ from $h_3$. It then uses, for example, proportional, integral and derivative (PID) feedback control to control the actuators 44 so that the seal member is the correct height above the substrate. Other methods of control are also suitable. For example, the control of the seal member relative to the substrate can be preformed indirectly using only the height, $h_4$h, of the seal member relative to the reference frame.

The distance between the substrate and the seal member is adjustable up to 2 mm, during exposure and up to 10 mm during mechanic start up on maintenance. The controller controls the seal member 36 with 3 degrees of freedom: displacement in the Z direction (parallel to the optical axis of the projection system PL) and rotations about axes perpendicular to the Z direction.

The seal member 36 is supported above the substrate W by the actuators 44. There is no need for a stiff connection between the substrate W and the seal member 36. This reduces the transmission of vibrations to the seal member 36 and simplifies the dynamics of the control of the substrate W in the Z direction.

Accordingly, the system of this embodiment can easily control the height of the seal member 36 above the surface of the substrate W to accommodate wide variations in the surface height of the substrate.

Although the use of Lorentz actuators 44 has been described other types of actuator are also suitable, for example electromagnetic, piezo or pneumatic actuators.

The control system may also be used to:

- effect active position measurement and control of the seal member with respect to the substrate to guarantee seal-functionality;
- damp the seal member with respect to the substrate to reduce the impact of disturbance generated in the seal member, e.g. vacuum fluctuations;
- gravity compensation, e.g. in combination with a gas-bearing that has a pre-tension by vacuum force;
- generate extra pre-tension forces, e.g. in combination with a liquid bearing;
- compensate for other external forces and moments, e.g. due to hose connections or fixation members in non-actuated directions; and
- provide actuated movement for general purposes, e.g. during substrate loading or maintenance.

It will be appreciated that the control system of this embodiment can be applied to the other embodiments described above.

Embodiment 5

A liquid supply system usable in a lithographic apparatus of the invention is illustrated in Figure 8. The construction of this embodiment is as for the first embodiment, save as described below.

A seal member 18 surrounds the final element of the projection system PL to define a space 2 which is filled with a liquid. In this embodiment the liquid is primarily distilled or purified water, although other liquids may also be used. Pressurized liquid is supplied to the space 2 by an inlet 20 formed on the surface of the seal member 18 which faces the substrate W (hereinafter referred to as the primary surface).

The liquid is removed at two locations. An upper outlet 22 removes liquid from near the top of the space 2. A lower outlet 24, formed in the primary surface of the seal member 4, removes liquid from the surface of the substrate W. Pressurized gas is supplied at two locations on the primary surface of the seal member 18 to ensure that the liquid remains in the space 2. A first gas inlet 28 is located radially inwards of the lower outlet 24 with respect to the optical axis of the projection system. It limits the flow of liquid to the lower outlet 24 by restricting the area available for the liquid to flow through to reach the lower outlet 24 and also decouples the pressure at inlet 20 from the pressure at lower outlet 24.

A low pressure or vacuum is maintained at the lower outlet 24 to suck liquid away as well as gas from the first gas inlet 28 and a second gas inlet 30. The flow of gas from the first gas inlet 28 to the lower outlet 24 enhances the liquid removal. The flow of gas from the second inlet 30 to lower outlet 24 is effective to create a gas seal. The gas supplied at the inlet 30 will also function to some extent as a gas bearing to help to support the seal member 18, and for as a gas jet, to assist in confining the immersion liquid.

A low pressure or vacuum is also maintained at a third outlet 26, located radially outwards from the lower outlet 24 with respect to the optical axis of the projection system. The third outlet 26 acts to remove gas from second gas inlet 30 and to keep such gas from reaching the remainder of the apparatus.

Figure 8 depicts the seal member 18 in cross section. It will be appreciated that the inlets 20, 28 and 30 and the outlets 22, 24 and 26 can extend continually around the liquid filled space 2, forming a groove when viewed from the surface of the substrate. This groove can be annular, rectangular or polygonal. Alternatively, the groove can extend continually around the liquid filled space 2, but the inlets and outlets can only be present at discrete positions in the groove, not continuously along its length.

Liquid is supplied at the inlet 20 for two reasons. Firstly, it refreshes the liquid in the space 2 and allows the temperature and level of contaminants to be controlled. Secondly, it reduces gas inclusion. Gas inclusion can arise as the substrate W moves relative to the projections lens PL, agitating the liquid and transporting it away from the space 2. The pressure required to supply the liquid to meet these two criteria is calculated by two different formulas.

To avoid gas inclusion, the pressure required is:

$$\Delta p = \frac{6nv\eta}{h_1} \qquad (1)$$

Where $n$ is a safety factor of the order of 10, $v$ is the scanning velocity, $\eta$ is the viscosity of the liquid and $h_1$ is the height of the primary face of the seal member above the surface of the wafer between inlet 20 and outlet 28. For water, with typical values of $v$=0.5 m/s and $h_1$=30 μm the relative pressure required is approximately 1000 Pa, which is relatively low.

To refresh the liquid in the space 2, the pressure required is:

$$\Delta p = \frac{6\Phi_{v,refresh}d_1\eta}{\pi r h_2^3} \qquad (2)$$

Where $\Phi_{v,refresh}$ is the refreshment rate, $h_2$ is the height of the primary face of the seal member above the surface of the wafer between inlet 20 and the space 2 and $d_1$ is the distance between the liquid inlet 20 and the inner radial edge of the seal member 18. For water, with a typical $\Phi_{v,refresh}$=1000 cm³/min, $r$=30 mm, $d_1$=3 mm and $h_2$=30 μm this gives a required relative pressure of approximately 100 kPa, which is high for practical applications. However, the inverse cube relationship to $h_2$ means that if $h_2$ can be increased by a factor of 4, the pressure is reduced by a factor of 64 resulting in an acceptable pressure of approximately 1.5 kPa. Other factors can be used to increase $h_2$ as well, for example at least 1.5, preferably 2 or 3 and ideally at least 4 as described above.

Therefore, to reduce the pressure required to refresh the liquid, the height $h_2$ of the seal member 18 above the surface of the wafer W is 120 μm only in the region between the liquid filled space 2 and the liquid inlet 20. The height $h_1$ of the other parts of the seal member 18 above the surface of the substrate W is 30 μm.

As well as reducing the pressure required to refresh the liquid this construction also reduces the excess liquid flow generated by the movement of the substrate W. This excess liquid flow is removed at the lower outlet 24. Removing liquid by the low pressure or vacuum at the outlet 24 may cause unwanted mechanical vibrations. Reducing the volume of liquid removed at the outlet 24 therefore reduces the chance of unwanted mechanical vibrations being generated.

The removal of liquid at the outlet 24 can be improved by making the height of the primary surface of the seal member 18 above the surface of the substrate W greater between the first gas inlet 28 and the outlet 24 than between the liquid inlet 20 and the first gas inlet 28 ($h_1$).

It will be appreciated that the dimensions given in this embodiment can be adjusted depending on the operating liquid pressure desired, or on the viscosity of the liquid used to fill the space 2.

Embodiment 6

In a sixth embodiment of the invention, which may be the same as any of the above described embodiments save as described below, an additional confinement of the liquid is effected by rotating part of the seal member.

As shown in Figure 9, which depicts the seal member 50 from below, the seal member, or at least lower part, is circular. A liquid inlet 51 in the shape of a ring is provided near the outer periphery of the seal member and a liquid outlet 52, again in the shape of a ring is provided outside the inlet 51. Inside the inlet 51, one or more spiral grooves 53 as provided on the lower surface of the seal member 50. When the seal member is rotated in the direction indicated, the grooves will effect a pumping action tending to urge the liquid towards the centre of the seal member.

Whilst specific embodiments of the invention have been described above, it will be appreciated that the invention may be practiced otherwise than as described. The description is not intended to limit the invention. The invention is defined by the claims.

**Claims**

1.  A lithographic projection apparatus comprising:

    - a radiation system (IL) for providing a projection beam (PB) of radiation;
    - a support structure (MT) for supporting patterning means (MA), the patterning means serving to pattern the projection beam according to a desired pattern;
    - a substrate table (WT) for holding a substrate (W);
    - a projection system (PL) for projecting the patterned beam onto a target portion of the substrate; and
    - a liquid supply system for providing a space between a final element of said projection system and said substrate with a liquid;

    **characterized in that** said liquid supply system comprises:

    - a seal member (3, 4, 18, 36) arranged between the final element of the projection system (PL) and the surface of the substrate (W) and extending along at least part of the boundary of said space between the final element of said projection system and said substrate; and
    - a liquid seal means for forming a seal between said seal member and the surface of the substrate, by a flow of liquid.

2.  Apparatus according to claim 1, wherein said liquid seal means is either a hydrostatic or a hydrodynamic bearing for at least partially supporting said seal member above the surface of said substrate.

3.  Apparatus according to claim 1 or 2, wherein said seal member further comprises a shared liquid outlet (8) for removing liquid from said space and from said liquid seal means.

4.  Apparatus according to claim 3, wherein said shared outlet is located on a surface of said seal member which faces said substrate and is positioned between said space and said liquid seal means.

5.  Apparatus according to claim 3 or 4, wherein said shared liquid outlet has a cross sectional area in a plane substantially parallel to said substrate which is greater than the cross sectional area of a liquid inlet (6).

6. Apparatus according to claim 1, wherein said seal member comprises a liquid inlet (6, 8, 9, 20, 38, 51) located on a surface of said seal member which faces said substrate.

7. Apparatus according to claim 6, wherein the height of said seal member above the surface of said substrate is greater in the region between said space and said liquid inlet than elsewhere.

8. Apparatus according to claim 7, wherein said liquid supply system further comprises a gas seal means (24, 26, 30) positioned outwards in a radial direction from said liquid inlet, for forming a gas seal between said seal member and the surface of said substrate.

9. Apparatus according to any one of claims 6 to 8, wherein said seal member further comprises an intermediate gas inlet (30) and a liquid outlet (24) respectively positioned outwards in a radial direction from said liquid inlet and both located on said surface of said seal member which faces said substrate.

10. Apparatus according to claim 9, wherein the height of said seal member above the surface of said substrate is greater between said intermediate gas inlet and said liquid outlet than between said liquid inlet and said intermediate gas inlet.

11. Apparatus according to claim 2, wherein the pressure of the liquid in said hydrostatic or hydrodynamic bearing is in the range of 100 Pa to 100 kPa relative to the ambient pressure.

12. Apparatus according to any one of the preceding claims, wherein said liquid supply system further comprises a low pressure source for preventing leakage of liquid in an outward radial direction, said low pressure source located on a surface of said seal member which faces said substrate.

13. Apparatus according to any one of the preceding claims, further comprising means (14) for applying a biasing force directed towards the surface of said substrate to said seal member.

14. Apparatus according to any one of the preceding claims, further comprising a member (16) connected between said seal member and a machine frame for supporting said seal member.

15. Apparatus according to any one of the preceding claims, wherein said seal member comprises at least one liquid inlet (6, 8, 9, 20, 38, 51), at least one liquid outlet (12, 22, 40, 52) and at least one combined outlet (7, 10, 24, 42) for both liquid and gas.

16. Apparatus according to any one of the preceding claims, wherein said liquid supply system supplies liquid to said space at a rate of 0.1 to 10 liters per minute.

17. Apparatus according to any one of the preceding claims, wherein said liquid supply system supplies liquid to said space at a pressure which compensates for liquid transported away from said space by relative movement between said substrate and said seal member.

18. Apparatus according to any one of the preceding claims, further comprising at least one chamber (32, 34) formed upstream of an inlet and/or downstream of an outlet of said seal member.

19. Apparatus according to any one of the preceding claims, further comprising:

- at least one sensor to establish the position of said seal member; and
- a control system to control at least one actuator (44) based on the position established by said sensor.

20. Apparatus according to claim 19, wherein said sensor establishing the distance between the surface of said substrate and said seal member at said control system controls said at least one actuator to maintain a desired distance between the surface of said substrate and said seal member.

21. Apparatus according to claim 19, wherein said control system controls said at least one actuator (44) to at least partly compensate for an external force on said seal member.

22. Apparatus according to claim 19, wherein said control system acts to damp said seal member.

23. Apparatus according to claim 19, wherein said control system is arranged to retract the seal member in the case of a system error.

24. Apparatus according to claim 19, wherein said control system is arranged to control said at least one actuator (44) to exert a pre-tension force on said hydrostatic or hydrodynamic bearing.

25. Apparatus according to any one of the preceding claims, wherein at least one inlet and/or outlet in said member has rounded edges.

26. Apparatus according to any one of the preceding claims, wherein at least one edge of said seal member adjacent to the surface of said substrate is rounded.

**Patentansprüche**

1. Lithographische Projektionsvorrichtung, umfassend:

   - ein Bestrahlungssystem (IL) zum Bereitstellen eines Projektionsstrahls (PB) aus Strahlung;
   - einen Halteraufbau (MT) zum Halten einer Musteraufbringungseinrichtung (MA), wobei die Musteraufbringungseinrichtung dazu dient, den Projektionsstrahl entsprechend einem erwünschten Muster zu mustern;
   - einen Substrattisch (WT) zum Halten eines Substrats (W);
   - ein Projektionssystem (PL) zum Projizieren des gemusterten Strahls auf einen Zielabschnitt des Substrats; und
   - ein Flüssigkeitszufuhrsystem zum Zuführen einer Flüssigkeit in einen Raum zwischen einem finalen Element des Projektionssystems und dem Substrat,

   **dadurch gekennzeichnet, dass** das Flüssigkeitszufuhrsystem umfasst:

   - ein Dichtelement (3, 4, 18, 36), das zwischen dem finalen Element des Projektionssystems (PL) und der Oberfläche des Substrats (W) angeordnet ist und sich über zumindest einen Teil der Grenze des Raums zwischen dem finalen Element des Projektionssystems und dem Substrat erstreckt; und
   - eine Flüssigkeitsdichteinrichtung zum Bilden einer Dichtung zwischen dem Dichtelement und der Oberfläche des Substrats durch einen Flüssigkeitsfluss.

2. Vorrichtung nach Anspruch 1, bei der die Flüssigkeitsdichteinrichtung entweder ein hydrostatisches oder ein hydrodynamisches Widerlager ist zum zumindest teilweise Stützen des Dichtelements oberhalb der Oberfläche des Substrats.

3. Vorrichtung nach Anspruch 1 oder 2, bei der das Dichtelement ferner einen gemeinsamen Flüssigkeitsauslass (8) umfasst zum Auslassen von Flüssigkeit aus dem Raum und aus der Flüssigkeitsdichteinrichtung.

4. Vorrichtung nach Anspruch 3, bei der der gemeinsame Auslass sich auf einer Oberfläche des Dichtelements befindet, die dem Substrat zugewandt ist und sich zwischen dem Raum und der Flüssigkeitsdichteinrichtung befindet.

5. Vorrichtung nach Anspruch 3 oder 4, bei der der gemeinsame Flüssigkeitsauslass eine Querschnittsfläche in einer Ebene im Wesentlichen parallel zu dem Substrat aufweist, die größer als die Querschnittsfläche eines Flüssigkeitseinlasses ist.

6. Vorrichtung nach Anspruch 1, bei der das Dichtelement einen Flüssigkeitseinlass (6, 8, 9, 20, 38, 51) aufweist, der sich auf einer Oberfläche des Dichtelements befindet, die dem Substrat zugewandt ist.

7. Vorrichtung nach Anspruch 6, bei der die Höhe des Dichtelements oberhalb der Oberfläche des Substrats in dem Bereich zwischen dem Raum und dem Flüssigkeitseinlass größer als an anderer Stelle ist.

8. Vorrichtung nach Anspruch 7, bei der das Flüssigkeitszufuhrsystem ferner eine Gasdichteinrichtung (24, 26, 30) aufweist, die in radialer Richtung außerhalb des Flüssigkeitseinlasses angeordnet ist zum Bilden einer Gasdichtung zwischen dem Dichtelement und der Oberfläche des Substrats.

9. Vorrichtung nach einem der Ansprüche 6 bis 8, bei der das Dichtelement ferner einen zwischenliegenden Gaseinlass (30) und einen Flüssigkeitsauslass (24) aufweist, die jeweils in radialer Richtung außerhalb des Flüssigkeitseinlasses angeordnet sind und die sich auf der Oberfläche des Dichtelements befinden, die dem Substrat zugewandt ist.

10. Vorrichtung nach Anspruch 9, bei der die Höhe des Dichtelements oberhalb der Oberfläche des Substrats zwischen dem zwischenliegenden Gaseinlass und dem Flüssigkeitsauslass größer als zwischen dem Flüssigkeitseinlass und dem zwischenliegenden Gaseinlass ist.

11. Vorrichtung nach Anspruch 2, bei der der Druck der Flüssigkeit in dem hydrostatischen oder hydrodynamischen Widerlager in dem Bereich von 100 Pa bis 100 kPa relativ zu dem Umgebungsdruck ist.

12. Vorrichtung nach einem der vorhergehenden Ansprüche, bei der das Flüssigkeitszufuhrsystem ferner eine Niedrigdruckquelle zum Verhindern einer Leckage an Flüssigkeit in radialer Richtung nach außen umfasst, wobei die Niedrigdruckquelle sich auf einer Oberfläche des Dichtelements befindet, die dem Substrat zugewandt ist.

13. Vorrichtung nach einem der vorhergehenden Ansprüche, ferner umfassend eine Einrichtung (14) zum Ausüben einer zur Oberfläche des Substrats hin gerichteten Vorspannkraft auf das Dichtelement.

14. Vorrichtung nach einem der vorhergehenden Ansprüche, ferner umfassend ein Element (16), das zwischen dem Dichtelement und einem Maschinenrahmen verbunden ist zum Stützten des Dichtelements.

15. Vorrichtung nach einem der vorhergehenden Ansprüche, bei der das Dichtelement mindestens einen Flüssigkeitseinlass (6, 8, 9, 20, 38, 51), mindestens einen Flüssigkeitsauslass (12, 22, 40, 52) und mindest einen kombinierten Auslass (7, 10, 24, 42) für sowohl die Flüssigkeit als auch das Gas aufweist.

16. Vorrichtung nach einem der vorhergehenden Ansprüche, bei der das Flüssigkeitszufuhrsystem dem Raum Flüssigkeit mit einem Durchsatz von 0,1 bis 10 Liter pro Minute zuführt.

17. Vorrichtung nach einem der vorhergehenden Ansprüche, bei der das Flüssigkeitszufuhrsystem dem Raum Flüssigkeit bei einem Druck zuführt, der die aus dem Raum durch Relativbewegung zwischen dem Substrat und dem Dichtelement abtransportierte Flüssigkeit kompensiert.

18. Vorrichtung nach einem der vorhergehenden Ansprüche, ferner umfassend mindestens eine Kammer (32, 34), die stromaufwärts eines Einlasses und/oder stromabwärts eines Auslasses des Dichtelements gebildet ist.

19. Vorrichtung nach einem der vorhergehenden Ansprüche, ferner umfassend:

    - mindestens einen Sensor, um die Position des Dichtelements festzulegen; und
    - ein Steuerungssystem, um mindestens einen Aktuator (44) basierend auf der von dem Sensor festgelegten Position zu steuern.

20. Vorrichtung nach Anspruch 19, bei der der Sensor, der den Abstand zwischen der Oberfläche des Substrats und dem Dichtelement bei dem Steuerungssystem festlegt, den mindestens einen Aktuator derart steuert, dass ein erwünschter Abstand zwischen der Oberfläche des Substrats und dem Dichtelement beibehalten wird.

21. Vorrichtung nach Anspruch 19, bei der das Steuerungssystem den mindestens einen Aktuator (44) derart steuert, dass eine äußere Kraft auf das Dichtelement zumindest teilweise kompensiert wird.

22. Vorrichtung nach Anspruch 19, bei der das Steuerungssystem derart agiert, dass das Dichtelement gedämpft wird.

23. Vorrichtung nach Anspruch 19, bei der das Steuerungssystem derart angeordnet ist, dass das Dichtelement im Falle eines Systemfehlers zurückgeholt wird.

24. Vorrichtung nach Anspruch 19, bei der das Steuerungssystem derart angeordnet ist, dass der mindestens eine Aktuator (44) so gesteuert wird, dass er eine Vorspannkraft auf das hydrostatische oder hydrodynamische Widerlager ausübt.

25. Vorrichtung nach einem der vorhergehenden Ansprüche, bei der zumindest ein Einlass und/oder ein Auslass in dem Element abgerundete Kanten aufweist.

26. Vorrichtung nach einem der vorhergehenden Ansprüche, bei der zumindest eine Kante des Dichtelements benachbart der Oberfläche des Substrats abgerundet ist.

## Revendications

1. Appareil de projection lithographique comprenant :

    - un système de rayonnement (IL) pour délivrer un faisceau de projection (PB) de rayonnement ;
    - une structure de support (MT) pour supporter des moyens de mise en forme (MA), les moyens de mise en forme servant à mettre en forme le faisceau de projection conformément à un motif voulu ;
    - une table de substrat (WT) pour supporter un substrat (W) ;
    - un système de projection (PL) pour projeter le faisceau mis en forme sur une partie cible du substrat ; et
    - un système d'alimentation en liquide pour créer un espace entre un élément final dudit système de projection et ledit substrat avec un liquide,

    **caractérisé en ce que** ledit système d'alimentation en liquide comprend :

    - un élément d'étanchéité (3, 4, 18, 36) disposé entre l'élément final du système de projection (PL) et la surface du substrat (W) et s'étendant le long d'au moins une partie de la frontière dudit espace entre l'élément final dudit système de projection et ledit substrat ; et
    - des moyens d'étanchéité au liquide pour former un joint entre ledit élément d'étanchéité et la surface du substrat, par un écoulement de liquide.

2. Appareil selon la revendication 1, dans lequel lesdits moyens d'étanchéité au liquide sont un palier hydrostatique ou hydrodynamique pour supporter au moins partiellement ledit élément d'étanchéité au-dessus de la surface dudit substrat.

3. Appareil selon la revendication 1 ou 2, dans lequel ledit élément d'étanchéité comprend en outre une sortie de liquide partagée (8) pour retirer du liquide dudit espace et desdits moyens d'étanchéité au liquide.

4. Appareil selon la revendication 3, dans lequel ladite sortie partagée est placée sur une surface dudit élément d'étanchéité qui est dirigée vers ledit substrat et est positionnée entre ledit espace et lesdits moyens d'étanchéité au liquide.

5. Appareil selon la revendication 3 ou 4, dans lequel ladite sortie de liquide partagée a une aire de section transversale dans un plan sensiblement parallèle audit substrat qui est plus grande que l'aire de section transversale d'une entrée de liquide (6).

6. Appareil selon la revendication 1, dans lequel ledit élément d'étanchéité comprend une entrée de liquide (6, 8, 9, 20, 38, 51) située sur une surface dudit élément d'étanchéité qui est dirigée vers ledit substrat.

7. Appareil selon la revendication 6, dans lequel la hauteur dudit élément d'étanchéité au-dessus de la surface dudit substrat est plus grande dans la zone entre ledit espace et ladite entrée de liquide qu'en tout autre endroit.

8. Appareil selon la revendication 7, dans lequel ledit système d'alimentation en liquide comprend en outre des moyens d'étanchéité au gaz (24, 26, 30) positionnés vers l'extérieur dans une direction radiale à partir de ladite entrée de liquide, pour former un joint à gaz entre ledit élément d'étanchéité et la surface dudit substrat.

9. Appareil selon l'une quelconque des revendications 6 à 8, dans lequel ledit élément d'étanchéité comprend de plus une entrée de gaz intermédiaire (30.) et une sortie de liquide (24) respectivement positionnées vers l'extérieur dans une direction radiale à partir de ladite entrée de liquide et toutes les deux situées sur ladite surface dudit élément d'étanchéité qui est dirigée vers ledit substrat.

10. Appareil selon la revendication 9, dans lequel la hauteur dudit élément d'étanchéité au-dessus de la surface dudit substrat est plus grande entre ladite entrée de gaz intermédiaire et ladite sortie de liquide qu'entre ladite entrée de liquide et ladite entrée de gaz intermédiaire.

11. Appareil selon la revendication 2, dans lequel la pression du liquide dans ledit palier hydrostatique ou hydrodynamique est dans la plage de 100 Pa à 100 kPa par rapport à la pression ambiante.

12. Appareil selon l'une quelconque des revendications précédentes, dans lequel ledit système d'alimentation en liquide comprend en outre une source à basse pression pour empêcher une fuite de liquide dans une direction radiale vers l'extérieur, ladite source à basse pression étant située sur une surface dudit élément d'étanchéité qui est dirigée vers ledit substrat.

13. Appareil selon l'une quelconque des revendications précédentes, comprenant en outre des moyens (14) pour appliquer une force de rappel dirigée vers la surface dudit substrat jusqu'audit élément d'étanchéité.

14. Appareil selon l'une quelconque des revendications précédentes, comprenant de plus un élément (16) raccordé entre ledit élément d'étanchéité et un châssis de machine pour supporter ledit élément d'étanchéité.

15. Appareil selon l'une quelconque des revendications précédentes, dans lequel ledit élément d'étanchéité comprend au moins une entrée de liquide (6, 8, 9, 20, 38, 51), au moins une sortie de liquide (12, 22, 40, 52) et au moins une sortie combinée (7, 10, 24, 42) pour à la fois du liquide et du gaz.

16. Appareil selon l'une quelconque des revendications précédentes, dans lequel ledit système d'alimentation en liquide délivre du liquide dans ledit espace à un débit de 0,1 à 10 litres par minute.

17. Appareil selon l'une quelconque des revendications précédentes, dans lequel ledit système d'alimentation en liquide délivre du liquide dans ledit espace à une pression qui compense du liquide évacué dudit espace par un mouvement relatif entre ledit substrat et ledit élément d'étanchéité.

18. Appareil selon l'une quelconque des revendications précédentes, comprenant en outre au moins une chambre (32, 34) formée en amont d'une entrée et/ou en aval d'une sortie dudit élément d'étanchéité.

19. Appareil selon l'une quelconque des revendications précédentes, comprenant de plus :

    - au moins un capteur pour établir la position dudit élément d'étanchéité ; et
    - un système de commande pour commander au moins un actionneur (44) sur la base de la position établie par ledit capteur.

20. Appareil selon la revendication 19, dans lequel ledit capteur établissant la distance entre la surface dudit substrat et ledit élément d'étanchéité sur ledit système de commande commande ledit au moins un actionneur pour maintenir une distance voulue entre la surface dudit substrat et ledit élément d'étanchéité.

**21.** Appareil selon la revendication 19, dans lequel ledit système de commande commande ledit au moins un actionneur (44) pour compenser au moins partiellement une force extérieure sur ledit élément d'étanchéité.

**22.** Appareil selon la revendication 19, dans lequel ledit système de commande agit pour amortir ledit élément d'étanchéité.

**23.** Appareil selon la revendication 19, dans lequel ledit système de commande est agencé pour rétracter l'élément d'étanchéité dans le cas d'une erreur de système.

**24.** Appareil selon la revendication 19, dans lequel ledit système de commande est agencé pour commander ledit au moins un actionneur (44) pour exercer une force de pré-tension sur ledit palier hydrostatique ou hydrodynamique.

**25.** Appareil selon l'une quelconque des revendications précédentes, dans lequel au moins une entrée et/ou sortie dans ledit élément a des bords arrondis.

**26.** Appareil selon l'une quelconque des revendications précédentes, dans lequel au moins un bord dudit élément d'étanchéité adjacent à la surface dudit substrat est arrondi.

## Fig. 1

Fig. 2

Fig. 3

Fig. 4

EP 1 494 079 B1

Fig. 5

Fig. 6

32

34

3'

7'

9'

W

Fig. 9

50

51

52

53

2

Fig. 7

EP 1 494 079 B1

# Fig. 8

**EP 1 494 079 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4509852 A
- WO 9949504 A
- EP 03252955 A
- EP 03257072 A
- EP 1420300 A
- EP 1598855 A